Europäisches Patentamt

European Patent Office

Office européen des brevets

(19)

(11) Publication number: **0 073 602**
**A2**

## EUROPEAN PATENT APPLICATION

(12)

(21) Application number: 82304349.2

(22) Date of filing: 18.08.82

(51) Int. Cl.³: **G 06 F 11/18**

(30) Priority: 20.08.81 GB 8125497

(43) Date of publication of application: 09.03.83
Bulletin 83/10

(84) Designated Contracting States: **CH DE FR IT LI NL SE**

(71) Applicant: **WESTINGHOUSE BRAKE AND SIGNAL COMPANY LIMITED, Foundry Lane, Chippenham Wiltshire SN15 1RT (GB)**

(72) Inventor: **Brown, Christopher Robert, Westinghouse Signals Foundry Lane, Chippenham Wiltshire SN15 1RT (GB)**

(74) Representative: **Page, Edmund John et al, PAGE & CO Temple Gate House Temple Gate, Bristol BS1 6PL (GB)**

(54) **Combining replicated sub-system outputs.**

(57) A system comprising replicated sub-systems (x, Y, Z) the outputs (5, 6, 7) of which are consolidated to provide a single output (9) by a majority voter (8) for reliability and availability. The integrity of the system, i. e. confidence in the single consolidated output (9), is provided by an electronic coincidence checking (10) arrangement which involves several levels of checking. A first level of checking is carried out on all sub-system outputs (5, 6, 7) by circuits in each sub-system channel. Thus, each channel assesses the other channels and itself for coincidence. These assessments ($X^1 Y^1 Z^1$; $X^2 Y^2 Z^2$; $X^3 Y^3 Z^3$) are then consolidated in respect of each sub-system at a second level and the final result (11, 12, 13) employed as an inhibit or power supply disabling control if a fault is declared in one sub-system.

Combining Replicated Sub-System Outputs

The invention relates to a system comprising a plurality of parallel replicated sub-systems the outputs of which are combined by a majority voter to provide a single consolidated output.

In electronic systems replication of sub-systems or parallel redundancy is employed as a means of increasing the integrity and availbility of outputs. For example, U.K. Patent Specification No. 2 022 895A describes three identical and parallel computer based sub-systems operating in identical manner to generate three parallel output signals which are combined by means of a majority voting apparatus to provide a single control output comprising the unanimous or majority output. An out-of-coincidence apparatus detects and indicates which, if any of the sub-systems, is in disagreement and preferably suspends its operaion.

It is preferred to use relay circuits because of the difficulty of providing suitable electronic circuits with the necessary inherent fail-safe characteristics. "Fail-safe" being defined as a preferred mode of failure to a chosen safe state. Relays on the other hand have been developed to the point where the chance of a failure to a non-chosen state is so remote as to be effectively negligible.

An object of the present invention is to a system with electronic majority voting and coincidence checking circuits which has a reliability and integrity at least as good as those achievable by relay circuits in the same system.

0073602

According to the present invention there is provided a system comprising a plurality of parallel replicated sub-systems the outputs of which are combined by a majority voter to provide a single consolidated output and sub-system output coincidence checking means to assure integrity of the consolidated output, wherein the coincidence checking means comprises apparatus in each sub-system channel connected to receive the outputs of all channels and arranged to perform a coincidence checking function and to provide an output to operate a fault indicator in the event of lack of coincidence with the majority, and apparatus for combining the fault indications relating to each sub-system to provide a single consolidated output declaring the integrity of each sub-system channel.

The invention and how it may be carried into practice will now be described, by way of example only, with reference to the accompanying drawings, in which:

Fig. 1 shows in functional block diagram form a system comprising three parallel sub-systems with majority voting and out-of-coincidence checking apparatus.

Fig. 2 also in block diagram form shows in greater detail the system of Fig. 1.

Fig. 3 shows diagrammatically sub-system power supply control by out-of-coincidence checking apparatus of Fig. 2,

Fig. 4A shows diagrammatically a relay majority voting apparatus,

Fig. 4B shows a majority voting apparatus using opto-couplers, and

Fig. 5 shows a functional flow chart for a micro-processor out-of-coincidence checking apparatus.

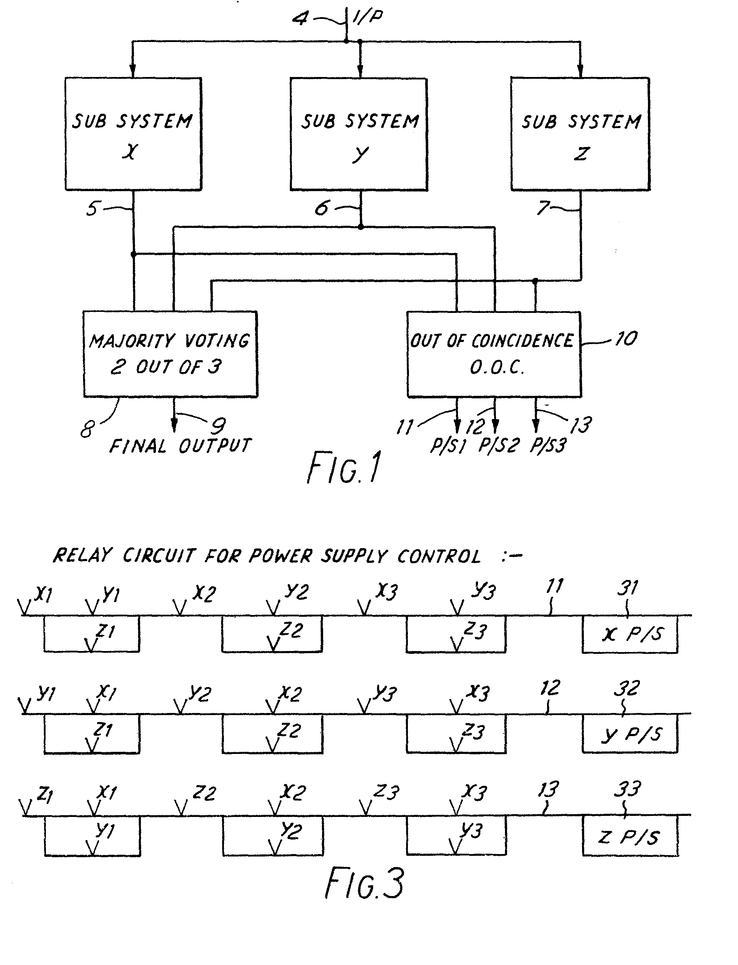

In the drawings the block diagram of Fig. 1 illustrates the functional organisation of a computer based railway interlocking system of the type described in Patent Specification No. 2 022 895A comprising three parallel redundant processing units or sub-systems X, Y and Z which receive, on a signal highway 4 a multiplicity of signals indicating the setting or status of railway traffic control devices, e.g. points, signals and track circuits, and route setting signals from a control panel not shown. The signal highway 4 may be a multiplexed data highway or alternatively dedicated wires but in all cases data sources are scanned cyclically and data is presented to the electronic processing units X, Y and Z in serial format. Data presentation therefore takes place in cycles in each of which all sources of data are scanned at least once. Similarly output signals are presented cyclically in serial data format on sub-system output lines 5, 6 and 7.

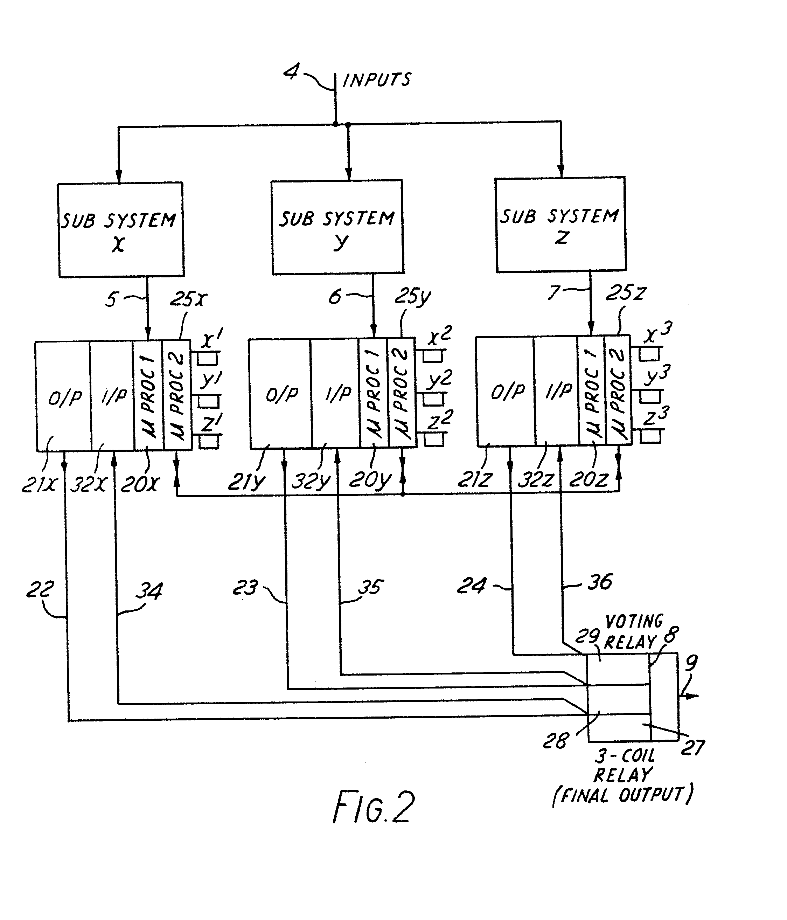

Fig. 2 shows in greater detail the arrangements for majority voting and coincidence checking. Each sub-system channel has an electronic housing comprising a multiplicity of electronic circuit cards which distribute control signals to the correct output lines and which include the majority voter and coincidence checking circuits. In each sub-system serial information is carried from a processing unit to a first electronic circuit $20_X$, $20_Y$ and $20_Z$ which checks the serial information for parity and then passes it on to a multiplexed serial data bus feeding an output buffer circuit $21_X$, $21_Y$ and $21_Z$. Each of the output buffer circuits is contained on an electronic circuit card dedicated to a traffic control device and possesses a unique address so that only signals or data words intended for that device are processed by the card. Each sub-system is similar in construction so that three parallel control signals are produced for each controlled device on lines 22, 23 and 24.

As these signals are computer generated none of them is fail-safe, that is, if a fault occurs in any component or section of a sub-system which affects the state of its output the effect is random rather than predetermined so that the output may fail to a dangerous state in some fault circumstances.

A high level of confidence in the fail-safe status of the outputs is achieved by combining the outputs from sub-systems X, Y and Z by means of majority voting apparatus, represented by block 8 in Fig. 1, to provide a single output on line 9. Thus, providing at least two of the three sub-systems generate correct outputs the single output 9 will be correct.

0073602

Statistically the chance of two of the sub-systems simultaneously generating incorrect output is extremely small so that the integrity of the single output 9 is very high. Using a fail safe relay arrangement, to be described below, the single output 9 is arranged to occupy a state corresponding to a potentially unsafe condition only if at least two of the sub-system outputs 5, 6 and 7 agree. Thus, if the relay or relay driving circuits suffer a fault the output 9 occupies a safe state and an output corresponding to a potentially unsafe state can only be held as long as at least two of the sub-systems are in agreement.

Clearly, however, a contribution from a faulty sub-system must be removed as soon as possible since a second fault could lead to a wrong side failure. To achieve this a coincidence check is carried out on the sub-system outputs 5, 6 and 7 by out-of-coincidence checking apparatus, block 10 in Fig. 1. In the event of one of the outputs 5, 6 and 7 being shown to be in disagreement by the out-of-coincidence apparatus operation of the offending sub-system is suspended pending remedial action being taken. The coincidence checking block 10 is arranged to generate outputs 11, 12 and 13 corresponding to each of the sub-systems, which outputs occupy a first state if the respective sub-system agrees with the majority or the sub-systems are unanimous and a second state if it disagrees with the majority. The coincidence check outputs 11, 12 and 13 are connected to operate switching means controlling energisation of the respective sub-systems in the sense that when a sub-system output is judged as a minority output the appropriate power supply is switched off to suspend operation of the sub-system.

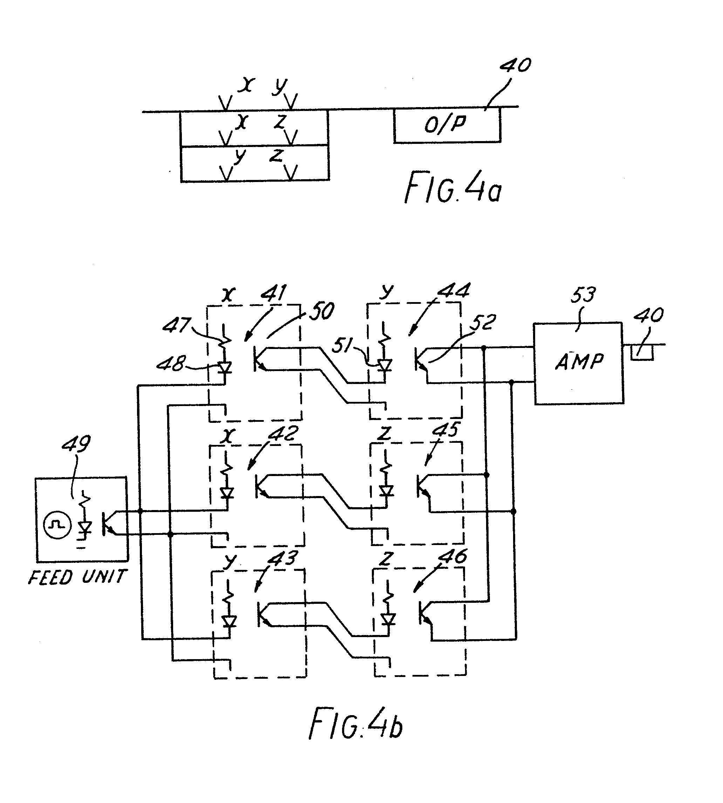

In the out-of-coincidence checking apparatus illustrated in Fig. 2 the outputs 5, 6 and 7 of each sub-system are supplied to a second electronic circuit on cards $25_X$, $25_Y$ and $25_Z$ via internal connections from the respective first circuit cards $20_X$, $20_Y$ and $20_Z$ and from the other sub-systems via a communal data highway 26. Each of the circuits on cards $25_X$, $25_Y$ and $25_Z$ is adapted to perform independently coincidence checking functions on the sub-system outputs supplied and to produce in respect of each sub-system an output indicative of the determined state of coincidence. Thus, there is produced for each sub-system three indications of its state of coincidence these are referenced at $X^1$, $Y^1$ and $Z^1$, $X^2$, $Y^2$ and $Z^2$, and $X^3$, $Y^3$ and $Z^3$ in Fig. 3.

In order to provide the checking arrangement with the desired level of integrity the coincidence checking function is executed simultaneously by the three electronic circuits $25_X$, $25_Y$ and $25_Z$ in the three sub-system channels and their indications combined by an arrangement of fail-safe relays (of the type previously referred to) connected as shown in Fig. 3 thereby providing fail-safe control of sub-system power supply switching means 31, 32 and 33. The electronic circuits $25_X$, $25_Y$ and $25_Z$ constitute a first level of non fail-safe checking and the relay arrangement of Fig. 3 comprises a second and fail-safe level of checking in which the initial coincidence indications are correlated according to a majority voting scheme in respect of each sub-system. Control of switching means 31 controlling the power supply of sub-system X is by correlation of the initial coincidence indications according to the logic function:

$X_1$ AND $(Y_1$ OR $Z_1)$ AND $X_2$ AND $(Y_2$ OR $Z_2)$ AND $X_3$ AND $(Y_3$ OR $2_3)$.

Similarly the corresponding logic functions for control of the power supply for sub-system Y is:

$Y_1$ AND $(X_1$ OR $Z_1)$ AND $Y_2$ AND $(X_2$ OR $Z_2)$ AND $Y_3$ AND $(X_3$ OR $2_3)$,

and for sub-system Z is:

$Z_1$ AND $(X_1$ OR $Y_1)$ AND $Z_2$ AND $(X_2$ OR $Y_2)$ AND $Z_3$ AND $(X_3$ OR $Y_3)$.

Therefore control of the power supplies is effectively made fail-safe since to maintain energisation of a sub-system power supply all three indications have to agree that the sub-system output is the same and is the majority output, under any other conditions the power supply is de-energised.

The electronic circuits referred to above for coincidence checking each omprise a data memory, e.g. a shift register into which output data from each of the replicated systems is written by a data reading means connected to all three sub-system outputs. When all corresponding outputs have scanned and the data entered the memory contents are mutually compared according to the appropriate coincidence checking logic equations. The comparison means has three outputs connected to fault indicators, e.g.

latch circuits, one for each sub-system and a lack of coincidence of a sub-system is flagged by setting of the corresponding latch.  Like the production of output data words in a sub-system this opration is performed cyclically so that every output is individually checked.

These electronic coincidence checking circuits may be constructed using discrete component circuitry, or more economically with integrated circuit logic gates, registers and memories, or still more economically using microprocessors and a control module containing an appropriate operating program.

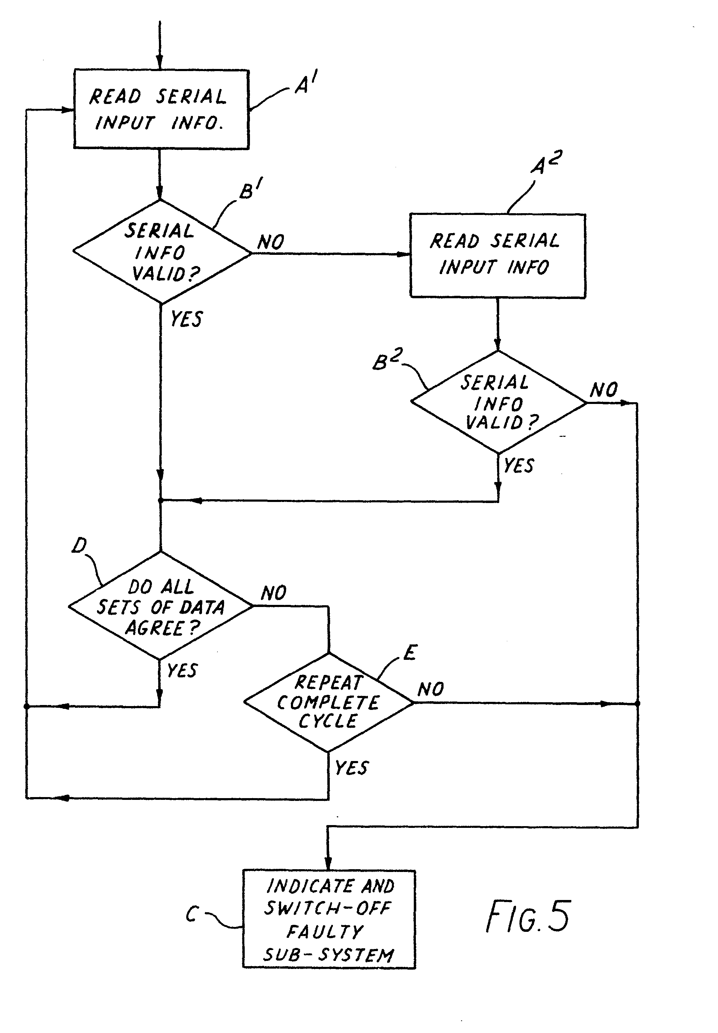

The microprocessor programs operate according to the functional flow chart illustrated in Fig. 5.  In function block A1 the output data from the sub-system processing unit is read, typically this comprises several bytes of digital data consisting of an address code indicating the device to which the next following information bits refer and at least one information bit which calls up the setting of the device.  Block B1 refers to a validity check e.g. a parity check on the byte, if this proves incorrect the byte is read again, block A2, and then rechecked block B2.  If the byte check is still incorrect the appropriate microprocessor output is switched to a state which indicates that the corresponding sub-system power supply, i.e. 31, 32 or 33, should be switched off as shown by function block C.  If either of the validity checks B1 or B2 shows a correct result the actual device setting information from all three sub-systems is checked for coincidence, function block D.  When all sets of data agree no action is taken but, if any set is out of coincidence the whole functional cycle is repeated in block E and if the same result is found on a second occasion the appropriate microprocessor output is switched to indicate the sub-system which is "at fault" in block C.

Majority voting arrangements were outlined above with reference to block 8 in Figs. 1 and 2 to provide the single output 9, and with reference to the power supply switching in Fig. 3 in which, for example, the logic function $X_1$ AND $(Y_1$ OR $Z_1)$ has to be determined.  In each of the cases a majority decision and a unanimous decision are given equal weight.  An arrangement of this type may be carried into practice by means of a three coil majority voting relay, as shown in Fig. 2, in which relay 8 comprises three energising coils 27, 28 and 29 and a magnetic circuit adapted to operate, i.e. to pull-in, the armature of the relay when at least two of the coils are energised.  Thus, when at least two of the signals 5, 6 and 7 are the same the corresponding coils are energised and the relay is operated.  The relay contacts, normally open or normally closed as required, are used to determine the state of the final output signal 9.

Altenatively the majority voting arrangement 8 of Fig. 1 may be realised employing conventional relay connections in which each sub-system output controls the energisation of a relay having two pairs of contacts.  The three possible combinations of three sets of two contacts connected in series is shown in Fig. 4A which provide a current path to energise a fourth relay 40 when at least any two of the three sub-system output relays are energised.

As a further alternative arrangement the majority voting circuit 8 may be carried into practice as shown in Fig. 4B using six opto-couplers 41 to 46 in place of the six relay contacts in which each sub-system output 5, 6 or 7 energises two opto-couplers. Referring in detail to the circuit of opto-coupler 41 the sub-system output 5 is connected to a current limiting resistor 47 in series with a light emitting diode 48 and a feed unit 49 which is driven by a pulse signal synchronised with the digital data output of the system processing units. The diode 48 is optically coupled to light sensitive transistor 50 which is connected in series with the light emitting diode 51 of another opto-coupler 44 connected to the sub-system output 6. Finally the respective light sensitive transistor 52 of opto-coupler 44 is connected to the input of an amplifier 53 which operates the final output relay 40. Two further pairs of opto-couplers 42, 45 and 43, 46 are connected between synchronised feed unit 49 and amplifier 53 in parallel with the first pair 41, 44 and the light emitting diode to these are energised in like manner by sub-system outputs 5, 6 and 7 respectively.

Confidence in the system is further improved by checks to detect dormant failures arising due to faults in hardware between the sub-system computer output stages and the relays 8 producing the single control signal 9. For example, in the case of a two aspect coloured light signal, a green aspect represents "proceed" and a red aspect represents "stop". When the track ahead of a light signal is clear it normally shows a green aspect so that by definition this is a potentially unsafe condition. In some circumstances therefore a signal may show a green aspect for long periods of time, a fault giving rise to permanent generation of a green aspect control signal is thus termed a dormant wrong side failure, since it would not normally be discovered until the next attempt is made to change the signal aspect to red. In the present system the green signal aspect is represented by a "1" signal and the red aspect by a "0" signal bit in the sub-system outputs 5, 6 and 7. The first microprocessor cards $20_X$, $20_Y$ and $20_Z$ in Fig. 2 are programmed to set a "1" signal bit, whenever it occurs, to a "0" state for a short time in each signal cycle. The interval of said short time must be less than the response time of relay 8 and typically, is of the order of 10ms. The signal is carried by the output cards $21_X$, $21_Y$ and $21_Z$ to the voting relay 8, feedback connections 34, 35 and 36 from the relay coils 26, 27 and 28 respectively return the signals via input cards $32_X$, $32_Y$ and $32_Z$ to the microprocessor cards $20_X$, $20_Y$ and $20_Z$. If the control signals at the relay 8 cannot be set back to a "0" state action is taken by the second microprocessor cards $25_X$, $25_Y$ and $25_Z$ to suspend operation of the output card $21_X$, $21_Y$ and $21_Z$ including the fault.

0073602

CLAIMS:

1. A system comprising a plurality of parallel replicated sub-systems the outputs of which are combined by a majority voter to provide a single consolidated output and sub-system output coincidence checking mans to assure integrity of the consolidated output, characterised in that the coincidence checking means (10) comprises apparatus ($25_X$, $25_Y$, $25_Z$) in each sub-system channel (X, Y, Z) connected to receive the outputs of all channels (5, 6, 7) and arranged to perform a coincidence checking function and to provide an output to operate a fault indicator ($X^1$, $Y^1$, $Z^1$; $X^2$, $Y^2$, $Z^2$; $X^3$, $Y^3$, $Z^3$) in the event of lack of coincidence with the majority, and apparatus (Fig. 3) for combining the fault indications relating to each sub-system (5, 6, 7) to provide a single consolidated output (11, 12, 13) declaring the integrity of each sub-system channel.

2. A system according to Claim 1 further characterised in that the consolidated output (11, 12, 13) declaring the consolidated output declaring the integrity of each sub-system (X, Y, Z) is connected to means (31, 32, 33) for disabling the output (5, 6, 7) of the sub-system (X, Y, Z).

3. A system according to Claim 2 further characterised in that the means for disabling the sub-system output comprises an output inhibiting circuit.

4. A system according to Claim 2 further characterised in that the means for disabling the sub-system output comprises a sub-system power supply control (31, 32, 33).

5. A system according to Claim 1 further characterised in that the apparatus for combining the sub-system coincidence indications comprises a majority voter (Fig. 4a; Fig. 4b).

6. A system according to any preceding claim further characterised in that the apparatus in each sub-system channel for performing the coincidence checking function comprises a data memory, data reading means connected to the output of each replicated sub-system for reading data in said outputs into the memory, data comparison means for comparing data stored in the memory, a plurality of fault indicators one for each sub-system which are responsive to the data comparison means, and control means for operating said apparatus in a succession of cycles each of which includes the steps of reading the sub-system output into the data memory, comparing the stored data and registering a fault in a corresponding fault indicator when a sub-system output fails to coincide with a majority of the remaining sub-system outputs.

7. A system according to any preceding claim wherein the replicated sub-systems each produce a plurality of outputs which are consolidated by a plurality of majority voters for connection to a

0073602

like plurality of control lines further characterised in that the fault indicator ($X^1$, $Y^1$, $Z^1$; $X^2$, $Y^2$, $Z^2$; $X^3$, $Y^3$, $Z^3$) in each sub-system channel is further connected to be operated by the output of a pulse testing circuit ($21_X$, $21_Y$, $21_Z$) wherein said pulse testing circuit is connected to inject a test pulse into the sub-system output (22, 23, 24) and is connected to the output majority voter (8) by a feedback connection (34, 35, 36), the testing circuit being arranged to respond to the absence of feedback of a test pulse to operate the fault indicator.

8. A system according to any preceding claim further characterised in that a majority voter (Fig. 4b) includes logic AND gating means (41, 44) for a pair of outputs comprising a first light emitting device (48) connected in a first energising circuit (47, 48, 49), a first terminal (X) in the first energising circuit for receiving a first of the pair of outputs capable of occupying a first state which inhibits energisation of the first light emitting device (48) or an alternative second state which permits energisation of the device, a first light responsive switching device (50) connected in a second energising circuit (Y, 50, 51) for a second light emitting device (51), a second terminal (Y) in the second energising circuit for receiving a second of the pair of outputs also capable of occupying a first state which inhibits energisation of the second light emitting device (51) or an alternative second

0073602

state which permits energisation of the device, a
second light responsive switching device (52)
connected to provide an output, and in parallel
therewith further second light responsive
switching devices of similar logic AND gating
means (42, 45; 43, 46) for further pairs (X, Z;
Y, Z) of outputs.

9.   A system according to any preceding claim further
characterised in that a majority voter (8)
comprises a relay (9) having a plurality of
energising coils (27, 28, 29) co-operating with a
magnetic circuit arranged so that the relay
operates when a majority of the coils (27, 28,
29) are energised.

FIG.1

RELAY CIRCUIT FOR POWER SUPPLY CONTROL :—

FIG.3

FIG.2

FIG.4a

FIG.4b

4/4    0073602

FIG. 5